# EUROPEAN PATENT SPECIFICATION

(11) **EP 0 405 576 B1**
(45) Date of publication and mention of the grant of the patent: **07.06.1995**
(21) Application number: 90112452.9
(22) Date of filing: 29.06.1990
(51) Int. Cl.: G11C 29/00

(54) **Semiconductor memory device**
Halbleiterspeichergerät
Dispositif de mémoire à semi-conducteur

(30) Priority: 30.06.1989 JP 169631/89
(43) Date of publication of application: 02.01.1991
(73) Proprietor: KABUSHIKI KAISHA TOSHIBA, Kawasaki-shi, Kanagawa-ken 210 (JP)
(72) Inventor: Furuyama, Tohru, Intel. Prop. Div., K.K. Toshiba, Tokyo 105 (JP)
(74) Representative: Lehn, Werner, Dipl.-Ing.

(56) References cited:
- EP-A- 0 055 906
- EP-A- 0 314 180
- US-A- 4 342 103
- US-A- 4 816 757

## Description

The present invention relates to a semiconductor memory incorporating a technique of applying an accelerated stress to a cell transistor of a semiconductor memory to ensure the reliability of a gate insulator of the cell transistor. The present invention relates particularly to a semiconductor memory device used in a dynamic RAM (referred to as a DRAM hereinafter) in which a boost voltage is applied to word lines, and a static RAM (referred to as a SRAM).

EP-A-0 055 906 (cf esp fig.5) discloses a semiconductor memory comprising a plurality of memory cells (Cin), a plurality of bit lines (Bn) coupled to the memory cells, a plurality of word lines (Wi) coupled to the memory cells, selecting means (RD) responsive to address data for selecting at least one of said word lines, driving means (Vpp) for driving selected ones of said word lines, said selecting means (RD) comprising MOS-transistors (Q47) whose sources are coupled to said driving means (Vpp) and whose drains are respectively coupled to said word lines (Wi), and said driving means (Vpp) including a voltage source sufficient to drive up all of said word lines (cf esp p.11, 1.33 - p.12, 1.10) during test operation.

EP-A 0 314 180 describes a non-volatile semiconductor memory having a stress circuit. The semiconductor memory disclosed herein comprises a memory cell group, a word line group connected to said memory cell group, a bit line group connected to said memory cell group and a drive circuit connected to said bit line group for driving, in a test mode all bit lines. In the test mode a high programming voltage is applied simultaneously to all the bit lines, while the word lines are kept in the non-selection state. A test signal of low voltage applied to the driving means is converted into a high voltage test signal by a potential converter circuit. In response to the high voltage test signal a test voltage is generated, which has the same level as the normal programming voltage. Since none of the word lines are selected in the test mode to keep all the memory cell MOS-transistors in the non-conductive state, the test voltage or stress voltage is applied to all the bit lines as it is. In this way, the test voltage or stress voltage is applied to the drains of all the memory cells. However, the stress voltage provided by the drive means is much determined by the load characteristics of transistors incorporated therein and a current characteristic of a clamp circuit provided therein. Thus, when driving many bit lines in the test mode simultaneously the capacitance of the drive circuit may be insufficient to rapidly drive up all the word lines to the desired test voltage in the screening test.

Now, first some further aspects of the screening test will be discussed.

A screening test to eliminate devices which inherently include a defect has been conventionally performed in order to ensure the reliability of a semiconductor device. The screening test mainly includes methods for accelerating an electric field and for accelerating a temperature. A burn-in method capable of simultaneously achieving the acceleration of an electric field and that of a temperature is frequently used as the screening test. The burn-in method is effective in a device having a possibility of malfunctioning in the earlier stage of its usage.

In the screening test of a semiconductor memory device using the burn-in method, word lines are sequentially accessed by address input. Therefore, when the word lines are sequentially accessed during the burn-in operation, a cell transistor connected to a word line receives a stress (more precisely the maximum stress) less frequently than a transistor of a peripheral circuit does.

For example, the number of word lines of a 4 Megabit (4 Mb) DRAM is 4096, and the number of word lines which are selected in one cycle from among the 4096 word lines, is only four. Access to all cell transistors is thus completed in 1024 cycles. In other words, the time for which a stress is applied to the cell transistor is only 1/1024 the time for which a stress is applied to the transistor of the peripheral circuit. This type of screening test is not advantageous, since it does not efficiently and rapidly test for a defective cell transistor and it may degrade peripheral circuity.

In recent DRAMs, generally, a Vcc/2 voltage which is a half of a power source voltage, is applied to a capacitor electrode of a memory cell.

The electric field on the capacitor film is weak so that, even though the insulation film is thin, it is usually reliable. However, the electric field is strong on the gate oxide film of a transistor to which a boosted voltage (e.g. around 1.5 Vcc) is applied so that, even though the oxide film is thick, it is more likely to be unreliable. Therefore, the transistor to which the boosted voltage is applied especially needs to undergo the screening test. However, it includes a cell transistor and, as described above, the efficiency of the screening test is only 1/1024.

It is accordingly an object of the present invention to provide a semiconductor memory device which overcomes the above drawback wherein a stress is infrequently applied to a cell transistor, because to improve the stress acceleration efficiency of the cell transistor it is desirable to undergo a proper screening test. This object is solved by a semiconductor memory as defined in claim 1 or in claim 9.

A semiconductor memory device according to one aspect of the present invention comprises: a plurality of memory cells; a plurality of word lines connected to the memory cell group; a plurality of bit lines connected to the memory cells; and a drive circuit connected to the word lines, for, in a test mode, driving all the word lines or, alternatively, for driving a select number of word lines whose number is more than that of the number of word lines which are selected in a normal operation mode.

A semiconductor memory device according to another aspect of the invention includes a plurality of memory cells; a plurality of word lines connected to the memory cells, each word line having two ends; a plurality of bit lines connected to the memory cells; a drive circuit connected to one end of the word lines, for driving a selected word line in a normal operation mode; and means connected to other end of the word lines, for, in a test mode, driving all the word lines or alternatively, for driving a select number of word lines whose number is more than that of the number of word lines selected in the normal operation mode.

A semiconductor memory device according to still another aspect of the present invention includes a plurality of memory cells; a plurality of word lines connected to the memory cells, each word line having two ends; a plurality of bit lines connected to the memory cells; a drive circuit connected to one end of the word lines, for driving selected word lines in a normal operation mode; and a plurality of MOS transistors whose drains are connected to other end of the word lines, whose gates are connected in common to one another, and whose sources are connected in common to one another.

A semiconductor memory device according to still another aspect of the present invention includes a plurality of memory cells; a plurality of word lines connected to the memory cells, each word line having two ends; a plurality of bit lines connected to the memory cells; a drive circuit connected to one end of the word lines, for driving selected word lines in a normal operation mode; a first plurality of MOS transistors whose drains are connected to other end of the word lines and whose gates are connected in common to one another; and a second plurality of MOS transistor whose drains are connected to sources of the first MOS transistors group, whose gates are connected in common to one another, and whose sources are connected in common to one another.

This invention can be more fully understood from the following detailed description when taken in conjunction with the accompanying drawings, in which:
Fig. 1 is a circuit diagram showing a semiconductor memory device according to a first embodiment of the present invention;
Fig. 2 is a circuit diagram showing a semiconductor memory device according to a second embodiment of the present invention;
Fig. 3 is a timing chart for explaining the semiconductor memory device shown in Fig. 2;
Fig. 4 is a circuit diagram showing a semiconductor memory device according to a third embodiment of the present invention; and
Fig. 5 is a circuit diagram showing a modification of a memory cell.

An embodiment of the present invention will be described in detail with reference to the accompanying drawings. The elements common to all the drawings are denoted by the same reference numerals to avoid repeating the descriptions of the same elements.

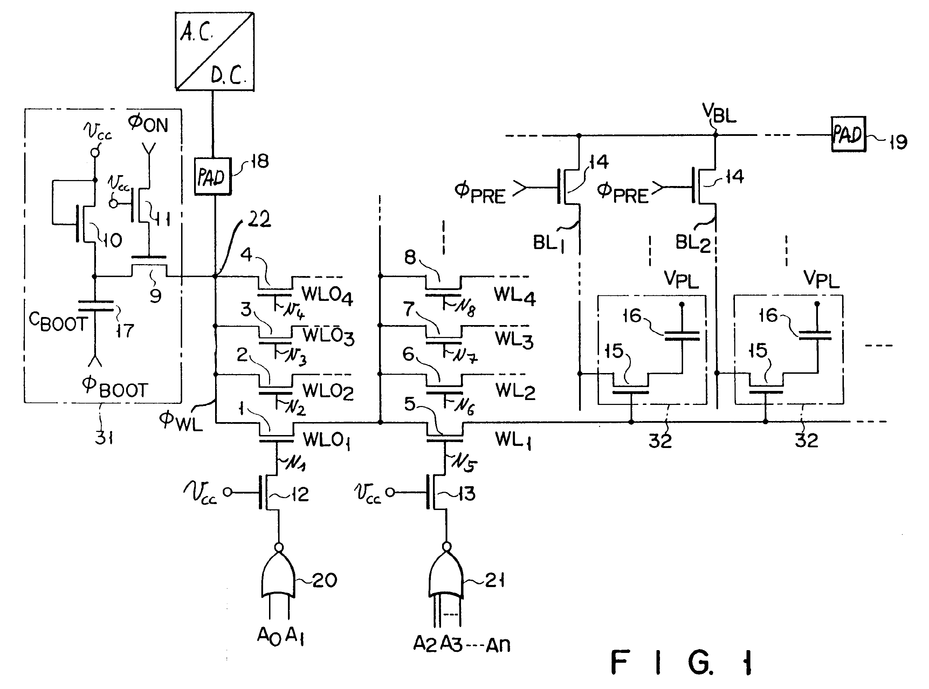

Fig. 1 is a circuit diagram showing a semiconductor memory device according to the first embodiment of the present invention. In Fig. 1, reference numerals 1 to 9 indicate transfer gates; 10 to 13, MOS transistors serving as barriers against a boosted voltage; 14, a MOS transistor for precharging a bit line; 15, a cell transistor of a memory cell; 16, a cell capacitor of a memory cell; 17, a MOS capacitor for boosting a voltage; 18 and 19, bonding pads; 20 and 21, NOR gates; 22, a node; WLOm (m = 1, 2, 3, 4), first word lines; WLn (n = 1, 2, 3, 4, ...), second word lines; BLn (n = 1, 2, ...), bit lines; φ_{BOOT}, a boosting signal; φ_{ON}, an on-signal of transfer gate 9; and φ_{WL}, drive signals of the word lines.

The first embodiment of the present invention is applied to a drive circuit for selecting a word line of memory cells.

Signal supply unit 31 for supplying drive signals φ_{WL} of the word lines in a normal operation mode is connected to node 22. Bonding pad 18, which is not used in the normal operation mode, is also connected to node 22. Further, first word lines WLOm (m = 1, 2, 3, 4) are connected to node 22 through transfer gates 1-4. Second word lines WLn (n = 1, 2, 3, 4, ...) are connected to first word line WLO₁ through the transfer gates (5, 6, 7, 8, ...). Similarly, second word lines (not shown) are connected to other first word lines WLOn (n = 2 to 4) through transfer gates (not shown). Transfer gates 1 to 4 have signals, one of which is selected according to addresses A₀ and A₁. Transfer gates 5, 6, 7, 8, ... have signals, one of which is selected according to addresses A₂ to Aₙ. Although not shown, it is to be understood the gates of transistors 2-4 and 6-8 are connected to circuitry similar to that connected to the gates of transistors 1 and 5, respectively. In the normal operation of the semiconductor device, transfer gates 1 to 4 and transfer gates 5, 6, 7, 8, ... are selectively turned on to select a word line. Memory cells 32 are connected to second word line WL₁. Similarly, memory cells (not shown) are connected to other second word lines WLn (n = 2, 3, 4). Memory cell 32 includes cell transistor 15 and cell capacitor 16. The gate of cell transistor 15 of memory cell 32 is connected to second word line WL₁. One of the electrodes of cell capacitor 16 is connected to the source of cell transistor 15. Cell plate voltage V_{PL} is applied to the other electrode of cell capacitor 16. A bit line BLn (n = 1, 2, ...) is connected to the drain of cell transistor 15. Bit line BLn is connected to the drain of MOS transistor 14 for precharging the bit line. Precharge signal φ_{PRE} is input to the gate of MOS transistor 14. Bonding pad 19, which is not used in the normal operation mode of the memory device, is connected to the source of MOS transistor 14.

In the semiconductor memory device so arranged, the number of word lines to be selected is controlled by addresses A₀ to Aₙ in the normal operation mode. In a stress application mode of a screening test, however, addresses A₀ to Aₙ are so controlled that transfer gates 1 to 4 and transfer gates 5, 6, 7, 8, ... can be all turned on. To turn on all these transfer gates, the levels of all the true and complement signals of addresses (A₀ to Aₙ and A̅₀̅ to A̅ₙ̅) supplied to NOR gates 20 and 21 need to be made low.

In the stress application mode of the present invention, transfer gates 1 to 4 and transfer gates 5, 6, 7, 8, ... are all turned on to drive all the word lines. However, capacitor 17 for boosting the voltage of the word lines has only enough capacitance (C_{BOOT}) to drive the word lines selected in the normal operation mode. In other words, capacitance CBOOT is insufficient to drive all the word lines and cannot be used for the screening test. In the present invention, therefore, bonding pad 18, which is not used in the normal operation, is connected to node 22. A desired voltage is applied from bonding pad 18 to node 22; accordingly, all the word lines are driven and a stress is applied to all cell transistors 15.

Similarly, bonding pad 19, which is not used in the normal operation mode, is connected to signal line V_{BL} for precharging the bit lines. In the screening test, a desired voltage (e.g., ground voltage Vss) is applied to bonding pad 19 and a desired voltage is thus applied to bit line BLₙ.

When direct current (D.C.) voltage is applied to bonding pad 18 to increase the acceleration efficiency of a stress applied to a gate insulation film of cell transistor 15, there is a strong possibility that the voltage of word line WLn (n = 1, 2, ...) is lowered by leakage as time passes. It is effective in this case to apply an alternating current (A.C.) voltage to bonding pad 18.

According to the semiconductor memory device as described above, the percentage of word lines to be selected from among all the word lines can be increased. More specifically, the stress application efficiency of the word lines can be improved 1000 to 2000 times that in a conventional acceleration method such as a burn-in method wherein only four word lines are selected from among 4096 word lines of the 4 Megabit (4Mb) DRAM. The time required for applying a stress in the present invention is thus 1/1000 to 1/2000 that in the conventional method and accordingly the efficiency of a screening test for the cell transistors of the memory cells can be greatly improved. If a defective transfer gate is found in advance in die sort, it can be replaced by a spare cell of the redundancy circuit. The test efficiency can be enhanced by shortening or eliminating the burn-in time after assembly of the semiconductor memory device.

Furthermore, the die sort can be performed after a weak cell transistor is found beforehand by inserting a process for applying a stress for a predetermined period of time. Since no stress is applied during the die sort, a tester need not be stopped for the stressing and an equipment can be effectively employed.

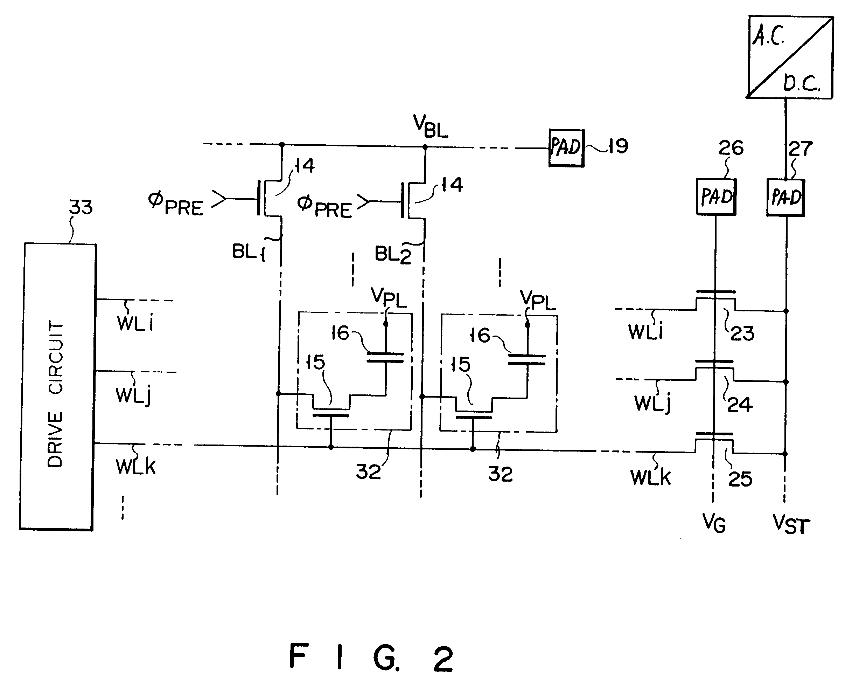

Fig. 2 is a circuit diagram showing a semiconductor memory device according to the second embodiment of the present invention. In Fig. 2, reference numerals 23 to 25 denote MOS transistors, 26 and 27 indicate bonding pads, and WLᵢ, WLⱼ and WLₖ show word lines.

According to the second embodiment, drive circuit 33 for driving a selected word line in a normal operation mode of the semiconductor memory device, is connected to one end of each of word lines WLᵢ, WLⱼ and WLₖ. The drains of MOS transistors 23 to 25 are connected to the other ends of word lines WLᵢ, WLⱼ and WLₖ, respectively. The gates of MOS transistors 23 to 25, which are connected in common to one another, are connected to bonding pad 26 which is not used in the normal operation mode. The sources of the MOS transistors, which are connected in common to one another, are connected to bonding pad 27 which is not used in the normal operation mode.

In the semiconductor memory device according to the second embodiment, desired stress voltage V_{ST} is applied to bonding pad 27 in the screening test, and gate voltage V_{G} which is higher than V_{ST} + V_{TH1} (V_{TH1} is threshold voltage of MOS transistors 23 to 25) is applied to bonding pad 26. MOS transistors 23 to 25 are thus turned on to drive all the word lines including WLᵢ, WLⱼ and WLₖ at once.

In the second embodiment, it is effective to supply a desired voltage to bit line BL₁ by applying a desired voltage (e.g., ground voltage Vss) to bonding pad 19.

In the second embodiment, either a direct current (D.C.) voltage or an alternating current (A.C.) voltage can be applied to bonding pad 27. To efficiently accelerate a cell transistor in view of time, it is desirable and simple to apply the direct voltage. If a voltage applied between the gates and sources of MOS transistors 23 to 25 is controlled so as to be equal to a voltage applied to the gate of a transfer gate of drive circuits 33 no problems occur in reliability of the gates of MOS transistors 23 to 25. Of course, MOS transistors 23 to 25 are turned off in the normal operation. This control can be realized, for example, by connecting the gates and sources of MOS-transistors 23 to 25 to a ground level (Vss) through very high resistive elements.

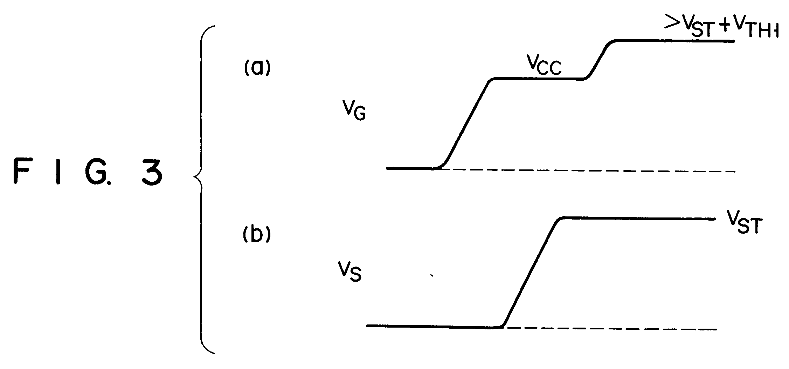

If the gate insulation films of MOS transistors 23 to 25 are likely to be destroyed, the screening test can be carried out at the timing shown in the graph of Fig. 3. More specifically, power supply voltage V_{CC} serving as gate voltage V_{G} is applied to bonding pad 26 and then voltage V_{ST} is applied to bonding pad 27. After the voltage of word lines WLᵢ, WLⱼ and WLₖ increases up to V_{CC} - V_{TH1}, a voltage serving as gate voltage V_{G}, which is higher than V_{ST} + V_{TH1}, is applied to bonding pad 26. Thus, a voltage which is higher than V_{ST} + V_{TH1} is not applied between the gates and sources of MOS transistors 23 to 25.

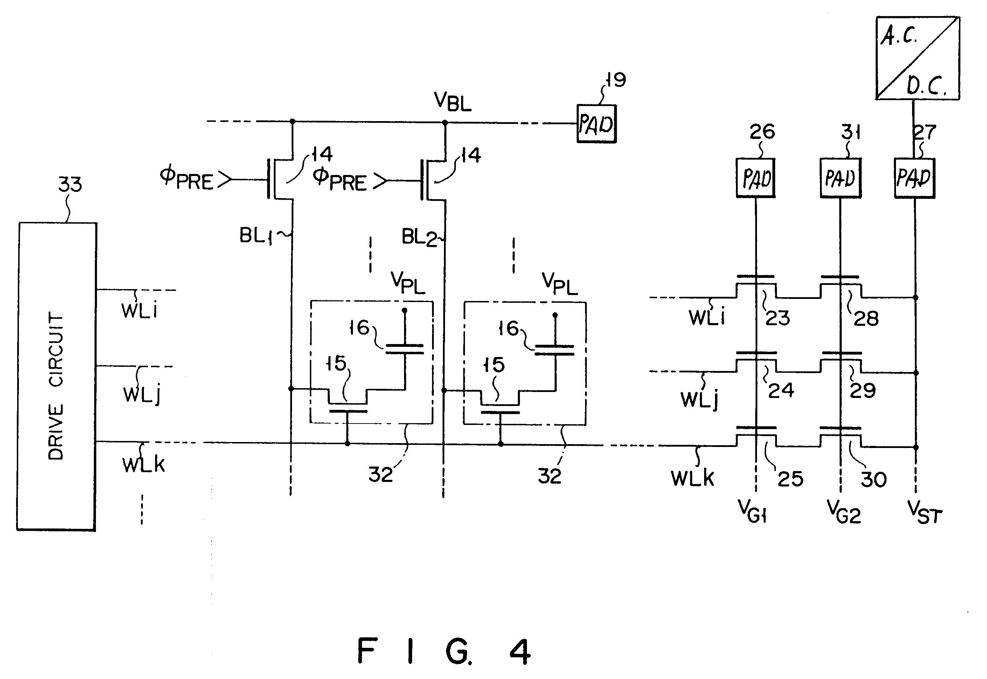

Fig. 4 illustrates a semiconductor memory device according to the third embodiment of the present invention. In Fig. 4, reference numerals 28 to 30 indicate MOS transistors, and numeral 31 denotes a bonding pad.

The third embodiment is a modification of the second embodiment and is very effective in preventing the reliability of the semiconductor memory device from being degraded in its normal operation. More specifically, the drains of MOS transistors (second MOS transistors) 28 to 30 are connected to the sources of MOS transistors (first MOS transistors) 23 to 25, respectively. The gates of MOS transistors 28 to 30 are connected in common to one another and are connected to bonding pad 31 which is not used in the normal operation. The sources of MOS transistors 28 to 30 are connected in common to one another and are connected to bonding pad 27 which is also not used in the normal operation.

In the semiconductor memory device according to the third embodiment, when a stress is applied, gate voltage V_{G1} applied to bonding pad 26 and gate voltage V_{G2} applied to bonding pad 31 are set to be not less than V_{ST} + V_{TH2} (V_{TH2} represents threshold voltages of MOS transistors 23-25 and 28-30). In the normal operation of the semiconductor memory device, for example, power supply voltage V_{cc} is applied to bonding pad 26 as gate voltage V_{G1}, and voltage V_{SS} (e.g., ground voltage) is applied to bonding pad 31 as gate voltage V_{G2}. This situation is realized, for example, by connecting node V_{G1} to a power supply level (Vcc), node V_{G2} and V_{S} to a ground level (Vss), respectively, through very high resistive elements. The drains of MOS transistors 28 to 30 are thus charged with V_{CC} - VTH₂ and, in other words, the potential of V_{CC} - V_{TH2} is applied to the gate oxide films of MOS transistors 28 to 30 when V_{SS} is a ground voltage, in the normal operation. Further, the voltage of V_{BOOT} (potential of a selected word line) - V_{CC} is applied to the gate oxide films of MOS transistors 23 to 25. It is therefore possible to solve the problem wherein the reliability of the device might be degraded in the normal operation. Since a voltage applied to the gate oxide films of MOS transistors 23 to 25 connected to non-selected word lines is V_{CC}, there is no problem of the degradation of the reliability.

The semiconductor memory devices according to the second and third embodiments have the same effects as obtained from the semiconductor memory device according to the first embodiment.

It is desirable that the sizes of MOS transistors 23-25 and 28-30 are determined so that, even though a stress may destroy a gate insulator film in a particular word line and a leakage decreases the level of voltage on the word line, a voltage applied to the other word lines cannot be influenced. Even if one portion of a gate insulator film is destroyed, the stress to the other part can be still accelerated.

In the first to third embodiments, a predetermined voltage is applied from a bonding pad which is not used in the normal operation mode. The bonding pad can be replaced with a bonding pad which is used in the normal operation mode by providing a means for switching its function between the normal operation mode and the stress application mode.

In the first to third embodiments, bonding pads used for the screening test can be shared by plural chips or shared by all the chips on a wafer.

In the first to third embodiments, all the word lines may be driven at once in the screening test. Alternatively, a select number of word lines whose number is not less than that of the word lines selected in the normal operation mode can be driven at once.

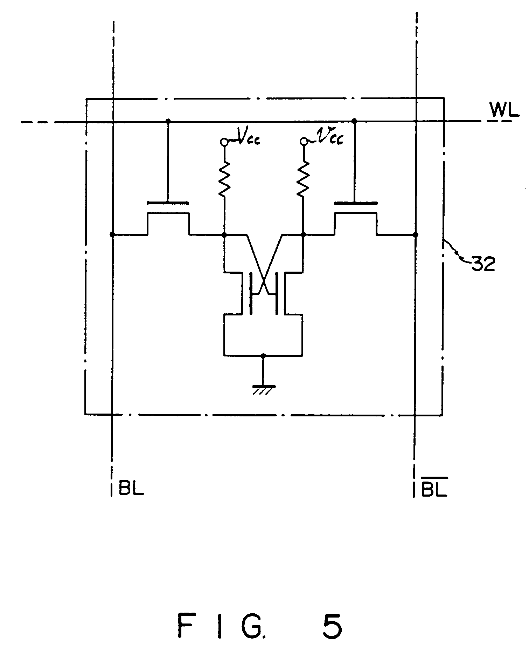

Though the above embodiments are applied to the DRAM, they can be applied to a SRAM in the same manner. More specifically, as shown in Fig. 5, memory cell 32 of the DRAM can be replaced with a memory cell of the SRAM. Two bit lines BL, B̅L̅ are usually connected to one SRAM cell and they can be connected to signal line V_{BL} through transistor 14 (shown in Figs. 1, 2 and 4) for precharging the bit line.

Reference signs in the claims are intended for better understanding and shall not limit the scope.

## Claims

1. A semiconductor memory, comprising:
a) a plurality of memory cells (15, 16; 32);
b) a plurality of bit lines (Bln) arranged such that each of said memory cells (15, 16; 32) is coupled to at least one bit line (Bln);
c) a plurality of first word lines (WL0m);
d) a plurality of second word lines (WLn) arranged such that each of said memory cells (15, 16; 32) is connected to one of said second word lines (WLn) and at least one of said second word lines (WLn) is coupled to one of said first word lines (WL0m);
e) selecting means (1-8) responsive to address data (A0-An) for selecting said one of said first word lines (WL0m) and said at least one of said second word lines (WLn); and
f) driving means (18, 22, 31) for driving said selected ones of said first and second word lines (WL0m; WLn);
g) said selecting means comprising:
first MOS-transistors (1-4) whose gates receive select signals, whose sources are coupled to said driving means (18, 22, 31) and whose drains are respectively coupled to said first word lines (WL0m); and
second MOS-transistors (5-8) whose gates receive select signals, whose sources are coupled to one of said first word lines (WL0m) and whose drains are respectively coupled to said second word lines (WLn); and
h) said driving means (18, 22, 31) including a first voltage source (18, 22) sufficient to drive up all of said first and second word lines (WL0m; Wln) during a test operation for detecting an erroneous operation of memory cells (15, 16; 32) of said semiconductor memory.

2. A semiconductor memory according to claim 1, wherein said memory is a dynamic random access memory.

3. A semiconductor memory according to claim 1, wherein said memory is a static random access memory.

4. A semiconductor memory according to claim 1, wherein said first voltage source (18, 22) comprises a voltage terminal pad (18) coupled to said first plurality of word lines (WL0m).

5. A semiconductor memory according to claim 4, wherein a direct current (D.C.) voltage is supplied to said voltage terminal pad (18).

6. A semiconductor memory according to claim 4, wherein an alternating current (A.C.) voltage is supplied to said voltage terminal pad (18).

7. A semiconductor memory according to claim 1, wherein said plurality of bit lines (BLi) is coupled to a second voltage source (VBL, 19).

8. A semiconductor memory according to claim 7, wherein said second voltage source (VBL) comprises a voltage terminal pad (19).

9. A semiconductor memory, comprising:
a) a plurality of memory cells (15, 16; 32);
b) a plurality of word lines (WLi, WLj, WLk) each word line (WLi, WLj, WLk) being coupled to a plurality of memory cells (15, 16; 32);
c) a plurality of bit lines (Bln) each bit line being coupled to a plurality of memory cells (15, 16; 32);
d) driving means (33) coupled to a first end of each of said plurality of word lines (WLi , WLj, WLk) for driving at least one of said word lines (WLi, WLj, WLk);
e) a plurality of first MOS-transistors (23-25) having their drains respectively coupled to the second ends of said plurality of word lines (WLi, WLj,,WLk) and having their respective gates coupled to each other; and
f) a plurality of second MOS-transistors (28-30) having their drains respectively coupled to the sources of said plurality of first MOS-transistors (23-25), having their respective gates coupled to each other and having their respective sources coupled to a first voltage source (27, Vs).

10. A semiconductor memory according to claim 9, wherein said first voltage source (27, Vs) comprises a voltage source (Vs) sufficient to simultaneously drive up to all of said word lines (WLi, WLj, WLk).

11. A semiconductor memory according to claim 9, wherein said first voltage source (Vs) is a direct current (D.C.) voltage source.

12. A semiconductor memory according to claim 9, wherein said first voltage source (Vs) is an alternating current (A.C.) voltage source.

13. A semiconductor memory according to claim 9, wherein said memory is a dynamic random access memory.

14. A semiconductor memory according to claim 9, wherein said memory is a static random access memory.

15. A semiconductor memory according to claim 9, wherein said first voltage source (27, Vs) comprises a voltage terminal pad (27) coupled to said plurality of word lines (WLi, WLj, WLk).

16. A semiconductor memory according to claim 9, wherein said plurality of bit lines (BLi) is coupled to a second voltage source (VBL, 19).

17. A semiconductor memory according to claim 16, wherein said second voltage source comprises a voltage terminal pad (19).

18. A semiconductor memory according to claim 9, wherein said respective gates of said plurality of first MOS-transistors (23-25) are coupled to a voltage terminal pad (26).

19. A semiconductor memory according to claim 18, wherein said respective gates of said plurality of second MOS-transistors (28-30) are coupled to a voltage terminal pad (31).

## Patentansprüche

1. Halbleiterspeicher, enthaltend
a) mittlere Speicherzellen (15, 16, 32),
b) mehrere Bitleitungen (Bln), die so angeordnet sind, daß jede der Speicherzellen (15, 16; 32) mit wenigstens einer Bitleitung (Bln) verbunden ist;
c) mehrere erste Wortleitungen (WL0m);
d) mehrere zweite Wortleitungen (WLn), die so angeordnet sind, daß jede der Speicherzellen (15, 16; 32) mit einer der zweiten Wortleitungen (WLn) verbunden ist, und daß mindestens eine der zweiten Wortleitungen (WLn) mit einer der ersten Wortleitungen (WL0m) verbunden ist;
e) auf Adreßdaten (A0-AN) reagierende Auswahlmittel (1-8) zum Auswählen von einer der ersten Wortleitungen (WL0m) und von mindestens einer der zweiten Wortleitungen (WLn); und
f) Treibermittel (18, 22, 31) zum Treiben der aus den ersten udn zweiten Wortleitungen (WL0m; WLn) ausgewählten Wortleitungen;
g) wobei die Auswahlmittel enthalten:
erste MOS-Transistoren (1-4), deren Gate-Elektroden Auswahlsignale empfangen, deren Source-Elektroden mit den Treibermitteln (18, 22, 31) verbunden sind und deren Drain-Elektroden jeweils mit den ersten Wortleitungen (WL0m) verbunden sind; und
zweite MOS-Transistoren (5-8), deren Gate-Elektroden Auswahlsignale empfangen, deren Source-Elektroden mit einer der ersten Wortleitungen (WL0m) verbunden sind und deren Drain-Elektroden jeweils mit den zweiten Wortleitungen (WLn) verbunden sind; und wobei
h) die Treibermittel (18, 22, 31) eine erste Spannungsquelle (18, 22) enthalten, die zum Treiben sämtlicher ersten und zweiten Wortleitungen (WL0m; WLn) während eines Testbetriebs zum Erfassen einer fehlerhaften Wirkungsweise von Speicherzellen (15, 16; 32) des Halbleiterspeichers ausreicht.

2. Halbleiterspeicher nach Anspruch 1, in dem der Speicher ein DRAM-Speicher ist.

3. Halbleiterspeicher nach Anspruch 1, in dem der Speicher ein SRAM-Speicher ist.

4. Halbleiterspeicher nach Anspruch 1, in dem die erste Spannungsquelle (18, 22) eine Spannungsanschlußfläche (18) enthält, die mit den mehreren ersten Wortleitungen (WL0m) verbunden ist.

5. Halbleiterspeicher nach Anspruch 4, in dem eine Gleichspannung (DC) der Spannungsanschlußfläche (18) zugeführt wird.

6. Halbleiterspeicher nach Anspruch 4, in dem eine Wechselspannung (AC) der Spannungsanschlußfläche (18) zugeführt wird.

7. Halbleiterspeicher nach Anspruch 1, in dem die mehreren Bitleitungen (Bli) an eine zweite Spannungsquelle (VBL, 19) angeschlossen sind.

8. Halbleiterspeicher nach Anspruch 7, in dem die zweite Spannungsquelle (VBL) eine Spannungsanschlußfläche (19) enthält.

9. Halbleiterspeicher, enthaltend
a) mehrere Speicherzellen (15, 16; 32);
b) mehrere Wortleitungen (WLi, WLj, WLk), wobei jede Wortleitung (WLi, WLj, WLk) mit mehreren Speicherzellen (15, 16; 32) verbunden ist;
c) mehrere Bitleitungen (Bln), wobei jede Bitleitung mit mehreren Speicherzellen (15, 16; 32) verbunden ist;
d) mit einem ersten Ende der mehreren Wortleitungen (WLi; WLj, WLk) verbundene Treibermittel (33) zum Treiben wenigstens einer der Wortleitungen (WLi, WLj, WLk);
e) mehrere erste MOS-Transistoren (23-25), deren Drain-Elektroden jeweils mit den zweiten Enden der Wortleitungen (WLi, WLj, WLk) verbunden sind und deren Gate-Elektroden miteinander verbunden sind; und
f) mehrere zweite MOS-Transistoren (28-30), deren Drain-Elektroden jeweils an die Source-Elektroden der ersten MoS-Transistoren (23-25) angeschlossen sind und deren Gate-Elektroden miteinander verbunden sind und deren Source-Elektroden an eine erste Spannungsquelle (27, Vs) angeschlossen sind.

10. Halbleiterspeicher nach Anspruch 9, in dem die erste Spannungsquelle (27, Vs) eine Spannungsquelle (Vs) enthält, mit der sich gleichzeitig alle Wortleitungen (WLi, WLj, WLk) auf einen hohen Pegel bringen lassen.

11. Halbleiterspeicher nach Anspruch 9, in dem die erste Spannungsquelle (Vs) eine Gleichspannungsquelle (DC) ist.

12. Halbleiterspeicher nach Anspruch 9, in dem die erste Spannungsquelle eine Wechselspannungsquelle (AC) ist.

13. Halbleiterspeicher nach Anspruch 9, in dem der Speicher ein DRAM-Speicher ist.

14. Halbleiterspeicher nach Anspruch 9, in dem der Speicher ein SRAM-Speicher ist.

15. Halbleiterspeicher nach Anspruch 9, in dem die erste Spannungsquelle (27, Vs) eine Spannungsanschlußfläche (27) enthält, die mit den mehreren Wortleitungen (WLi, WLj, WLk) verbunden ist.

16. Halbleiterspeicher nach Anspruch 9, in dem die mehreren Bitleitungen (BLi) mit einer zweiten Spannungsquelle (VBL, 19) verbunden sind.

17. Halbleiterspeicher nach Anspruch 16, in dem die zweite Spannungsquelle eine Spannungsanschlußfläche (19) enthält.

18. Halbleiterspeicher nach Anspruch 9, in dem die Gate-Elektroden der mehreren ersten MOS-Transistoren (23-25) mit einer Spannungsanschlußfläche (26) verbunden sind.

19. Halbleiterspeicher nach Anspruch 18, in dem die Gate-Elektroden der mehreren zweiten MOS-Transistoren (28-30) mit einer Spannungsanschlußfläche (31) verbunden sind.

## Revendications

1. Mémoire à semiconducteurs, comportant :
a) une pluralité de cellules de mémoire (15, 16 ; 32) ;
b) une pluralité de lignes de transmission de bits (BLn) disposées de telle sorte que chacune desdites cellules de mémoire (15, 16 ; 32) soit couplée à au moins une ligne de transmission de bits (BLn) ;
c) une pluralité de premières lignes de transmission de mots (WLOm) ;
d) une pluralité de secondes lignes de transmission de mots (WLn) disposées de telle sorte que chacune desdites cellules de mémoire (15, 16 ; 32) est connectée à l'une desdites secondes lignes de transmission de mots (WLn) et au moins l'une desdites secondes lignes de transmission de mots (WLn) est couplée à l'une desdites premières lignes de transmission de mots (WLOm) ;
e) des moyens de sélection (1-8) sensibles à des données d'adresse (A₀-Aₙ) pour sélectionner l'une desdites premières lignes de transmission de mots (WLOm) et ladite au moins une desdites secondes lignes de transmission de mots (WLn) ; et
f) des moyens de commande (22, 31) pour commander lesdites lignes sélectionnées desdites premières et secondes lignes de transmission de mots (WLOm ; WLn) ;
g) lesdits moyens de sélection comprenant :
des premiers transistors MOS (1-4) dont les grilles reçoivent des signaux de sélection, dont les sources sont couplées auxdits moyens de commande (22, 31) et dont les drains sont respectivement couplés auxdites premières lignes de transmission de mots (WLOm) ; et
des seconds transistors MOS (5-8) dont les grilles reçoivent des signaux de sélection, dont les sources sont couplées à l'une desdites premières lignes de transmission de mots (WLOm) et dont les drains sont respectivement couplés auxdites secondes lignes de transmission de mots (WLn) ; et
h) lesdits moyens de commande (22, 31) comprenant une première source de tension (18, 22) suffisante pour commander la totalité desdites premières et secondes lignes de transmission de mots (WLOm ; WLn) durant une opération d'essai pour détecter un fonctionnement erroné de cellules de mémoire (15, 16 ; 32) de ladite mémoire à semiconducteurs.

2. Mémoire à semiconducteurs selon la revendication 1, dans laquelle ladite mémoire est une mémoire à accès sélectif dynamique.

3. Mémoire à semiconducteurs selon la revendication 1, dans laquelle ladite mémoire est une mémoire à accès sélectif statique.

4. Mémoire à semiconducteurs selon la revendication 1, dans laquelle ladite première source de tension (18, 22) comporte un bloc terminal de tension (18) couplé à ladite première pluralité de lignes de transmission de mots (WLOm).

5. Mémoire à semiconducteurs selon la revendication 4, dans laquelle une tension continue est appliquée audit bloc terminal de tension (18).

6. Mémoire à semiconducteurs selon la revendication 4, dans laquelle une tension alternative est appliquée audit bloc terminal de tension (18).

7. Mémoire à semiconducteurs selon la revendication 1, dans laquelle ladite pluralité de lignes de transmission de bits (BLi) est couplée à une seconde source de tension (VBL, 19).

8. Mémoire à semiconducteurs selon la revendication 7, dans laquelle ladite seconde source de tension (VBL) comporte un bloc terminal de tension (19).

9. Mémoire à semiconducteurs, comportant :
a)une pluralité de cellules de mémoire (15, 16 ; 32) ;
b) une pluralité de lignes de transmission de mots (WLi, WLj, WLk), chaque ligne de transmission de mots (WLi, WLj, WLk) étant couplée à une pluralité de cellules de mémoire (15, 16 ; 32) ;
c) une pluralité de lignes de transmission de bits (BLn), chaque ligne de transmission de bits étant couplée à une pluralité de cellules de mémoire (15, 16; 32) ;
d) des moyens de commande (33) couplés à une première extrémité de chacune de ladite pluralité de lignes de transmission de mots (WLi, WLj, WLk) pour commander au moins l'une desdites lignes de transmission de mots (WLi, WLj, WLk) ;
e) une pluralité de premiers transistors MOS (23-25) ayant leurs drains respectivement couplés aux secondes extrémités de ladite pluralité de lignes de transmission de mots (WLi, WLj, WLk) et ayant leurs grilles respectives réunies les unes aux autres ; et
f) une pluralité de seconds transistors MOS (28-30) ayant leurs drains respectivement couplés aux sources de ladite pluralité de premiers transistors MOS (23-25), ayant leurs grilles respectives réunies les unes aux autres et ayant leurs sources respectives couplées à une première source de tension (27, Vs).

10. Mémoire à semiconducteurs selon la revendication 9, dans laquelle ladite première source de tension (27, Vs) comporte une source de tension (Vs) suffisante pour commander simultanément la totalité desdites lignes de transmission de mots (WLi, WLj, WLk).

11. Mémoire à semiconducteurs selon la revendication 9, dans laquelle ladite première source de tension (Vs) est une source de tension continue.

12. Mémoire à semiconducteurs selon la revendication 9, dans laquelle ladite première source de tension (Vs) est une source de tension alternative.

13. Mémoire à semiconducteurs selon la revendication 9, dans laquelle ladite mémoire est une mémoire à accès sélectif dynamique.

14. Mémoire à semiconducteurs selon la revendication 9, dans laquelle ladite mémoire est une mémoire à accès sélectif statique.

15. Mémoire à semiconducteurs selon la revendication 9, dans laquelle ladite première source de tension (27, Vs) comporte un bloc terminal de tension (27) couplé à ladite pluralité de lignes de transmission de mots (WLi, WLj, WLk).

16. Mémoire à semiconducteurs selon la revendication 9, dans laquelle ladite pluralité de lignes de transmission de bits (BLi) est couplée à une seconde source de tension (VBL, 19).

17. Mémoire à semiconducteurs selon la revendication 16, dans laquelle ladite seconde source de tension comporte un bloc terminal de tension (19).

18. Mémoire à semiconducteurs selon la revendication 9, dans laquelle lesdites grilles respectives de ladite pluralité de premiers transistors MOS (23-25) sont couplées à un bloc terminal de tension (26).

19. Mémoire à semiconducteurs selon la revendication 18, dans laquelle lesdites grilles respectives de ladite pluralité de seconds transistors MOS (28-30) sont couplées à un bloc terminal de tension (31).
